(19) Europäisches Patentamt
European Patent Office
Office européen des brevets

(11) **EP 3 707 565 B1**

(12) **FASCICULE DE BREVET EUROPEEN**

(45) Date de publication et mention
de la délivrance du brevet:
**03.11.2021 Bulletin 2021/44**

(51) Int Cl.:
*G04B 31/06* (2006.01)         *G04F 7/08* (2006.01)
*G04D 3/00* (2006.01)          *B81B 3/00* (2006.01)
*G04B 15/14* (2006.01)         *G04B 31/02* (2006.01)

(21) Numéro de dépôt: **18807437.1**

(22) Date de dépôt: **12.11.2018**

(86) Numéro de dépôt international:
**PCT/IB2018/058867**

(87) Numéro de publication internationale:
**WO 2019/092666 (16.05.2019 Gazette 2019/20)**

(54) **DISPOSITIF POUR GUIDAGE EN ROTATION D'UN COMPOSANT MOBILE**

VORRICHTUNG ZUR ROTATIONSSTEUERUNG EINER BEWEGLICHEN KOMPONENTE

DEVICE FOR GUIDING THE ROTATION OF A MOBILE COMPONENT

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **10.11.2017 EP 17200969**

(43) Date de publication de la demande:
**16.09.2020 Bulletin 2020/38**

(73) Titulaire: **Patek Philippe SA Genève
1204 Genève (CH)**

(72) Inventeur: **LE BRIS, Jean-Baptiste
74970 Marignier (FR)**

(74) Mandataire: **Micheli & Cie SA
Rue de Genève 122
Case Postale 61
1226 Genève-Thônex (CH)**

(56) Documents cités:
**EP-A1- 2 104 006     EP-A1- 2 105 807
CH-A2- 710 979        US-A- 2 606 447**

- **Levi Clifford Leishman: "Toward the Design of a
  Statically Balanced Fully Compliant Joint for use
  in Haptic Interfaces", All Thesis and
  Dissertations, 22 septembre 2011 (2011-09-22),
  pages 45-61, XP055476972, Provo, Utah Extrait
  de l'Internet:
  URL:https://scholarsarchive.byu.edu/etd/28 56
  [extrait le 2018-05-18]**
- **Ezekiel G. Merriam: "Fully Compliant
  Mechanisms for Bearing Subtraction in Robotics
  and Space Applications", All Thesis and
  Dissertations, 23 avril 2013 (2013-04-23), pages
  7-15, XP055479661, Provo, Utah Extrait de
  l'Internet:
  URL:https://scholarsarchive.byu.edu/etd/35 64
  [extrait le 2018-05-30]**

**Description**

La présente invention concerne un dispositif, typiquement horloger, pour le guidage d'un composant mobile en rotation.

En horlogerie, les composants mobiles en rotation tels que les bascules ou les ancres d'échappement sont traditionnellement guidés en rotation par des axes physiques qui soit sont fixes soit ont des pivots qui tournent dans des pierres. De tels axes physiques présentent l'inconvénient d'engendrer des frottements et donc une perte considérable d'énergie. En outre, un moment de rappel parasite est exercé sur l'axe.

Pour pallier cet inconvénient, des dispositifs de guidage flexible ont été mis au point, comme par exemple des dispositifs de guidage flexible à lames croisées, séparées ou non. De tels pivotements flexibles définissent un axe de rotation uniquement virtuel pour le composant mobile et présentent donc l'avantage d'annuler les frottements. Cependant, ils présentent l'inconvénient d'engendrer un moment de rappel qui, dans certaines utilisations, est indésirable ou trop important, un tel moment engendrant une surconsommation d'énergie. Pour diminuer ce moment de rappel une possibilité consistant à réaliser des guidages flexibles avec des lames présentant de très faibles raideurs n'est pas convenable car des lames de très faible raideur sont généralement fines et donc fragiles et difficiles à fabriquer. De plus, des lames de très faible raideur entraînent un guidage moins précis qu'un guidage avec des lames plus épaisses. En particulier, de telles lames engendrent des déplacements parasites hors du plan de rotation. En outre, une telle méthode ne peut permettre d'annuler complètement le moment de rappel.

Afin d'annuler le moment de rappel, dans la thèse "Toward the Design of a Statically Balanced Fully Compliant Joint for use in Haptic Interfaces", http://hdl.lib.byu.edu/1877/ etd4781, Levi Clifford Leishman a présenté un dispositif à lames croisées séparées doté également de deux organes élastiques exerçant des moments de rappel élastique qui se compensent au moins partiellement et ensemble compensent le moment de rappel des lames croisées. Chacun des deux organes élastiques comportant huit segments rigides et neuf éléments de rappel, ces organes élastiques ne sont pas agencés pour guider un élément mobile en rotation.

Un but de la présente invention est de proposer un dispositif de guidage d'un composant mobile en rotation qui soit précis et qui permette d'annuler les frottements tout en atténuant voire en supprimant tout moment de rappel.

L'invention propose à cette fin un dispositif comprenant un élément fixe, un élément mobile et des premier et deuxième organes élastiques reliant l'élément fixe et l'élément mobile et étant agencés pour guider l'élément mobile en rotation par rapport audit élément fixe, dispositif dans lequel chacun des premier et deuxième organes élastiques est agencé pour exercer sur l'élément mobile un moment de rappel élastique sensiblement constant sur une plage prédéterminée de positions angulaires de l'élément mobile par rapport à l'élément fixe d'au moins 10°, les moments de rappel élastique exercés par les premier et deuxième organes élastique se compensant au moins partiellement dans toute ladite plage prédéterminée.

L'invention propose également un procédé selon la revendication 16 de réalisation d'un tel dispositif, un ensemble horloger comprenant un tel dispositif et un composant horloger solidaire en rotation de l'élément mobile, ainsi qu'une pièce d'horlogerie telle qu'une montre-bracelet ou une montre de poche, comprenant un tel ensemble.

D'autres caractéristiques et avantages de la présente invention apparaîtront à la lecture de la description détaillée suivante faite en référence aux dessins annexés dans lesquels :

- la figure 1 est une vue en perspective d'un dispositif selon un premier mode de réalisation de l'invention ;
- la figure 2 est une vue en perspective d'une unité isolée du dispositif représenté à la figure 1 ;
- la figure 3 est une représentation graphique schématique illustrant l'allure de la courbe d'évolution du moment de rappel élastique exercé dans l'unité isolée de la figure 2 ;
- la figure 4 représente les coordonnées de points définissant une forme particulière de lame élastique pour l'unité isolée de la figure 2 ;
- la figure 5 est une représentation graphique du moment de rappel élastique exercé dans l'unité isolée représentée à la figure 2 comprenant des lames élastiques de forme telle que représentée à la figure 4;
- la figure 6 est une vue en perspective d'une étape de réalisation du dispositif représenté à la figure 1 ;
- les figures 7a et 7b sont des représentations schématiques décrivant des étapes successives de la réalisation du dispositif représenté à la figure 1 ;
- la figure 8 est une représentation graphique du moment de rappel élastique exercé dans chacune des unités du dispositif de la figure 1 ainsi que du moment de rappel élastique exercé sur un ensemble comprenant des moyeux faisant partie des deux unités du dispositif représenté à la figure 1 lors de sa rotation par rapport à un ensemble comprenant des serges faisant également partie desdites deux unités ;
- les figures 9a et 9b représentent en perspective un dispositif selon un second mode de réalisation de l'invention à différents stades de sa réalisation ;
- la figure 10 est une représentation graphique des moments de rappel élastique exercés dans chacune des unités du dispositif représenté à la figure 9b ainsi que du moment de rappel élastique exercé sur un ensemble comprenant des moyeux faisant partie des deux unités du dispositif représenté à la figure 9b lors de sa rotation par rapport à un ensemble comprenant des serges faisant également partie desdites deux unités ;

- la figure 11 est une représentation en perspective d'une variante d'un dispositif selon le premier mode de réalisation de l'invention ;
- la figure 12 est une vue partielle en perspective d'un dispositif selon un second mode de réalisation de l'invention intégré dans un mécanisme horloger ;
- la figure 13 est une vue de dessus d'une variante d'une unité utilisable dans un dispositif selon le premier ou selon le second mode de réalisation de l'invention.

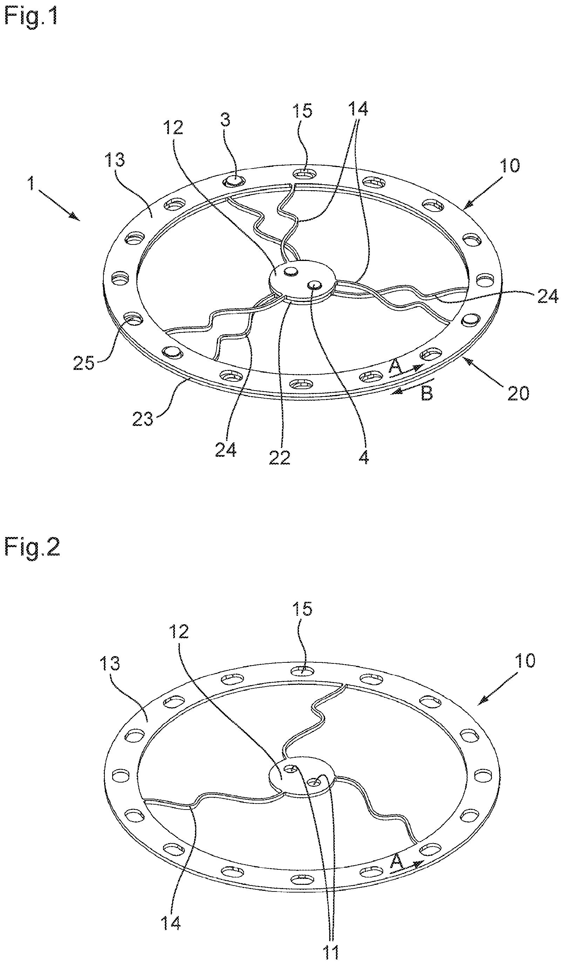

La figure 1 représente un dispositif 1, typiquement horloger, selon un premier mode de réalisation de l'invention comprenant une première 10 et une deuxième 20 unité monolithique superposées. Chacune de ces unités 10, 20 comprend un moyeu 12, 22 et une serge 13, 23 reliés par un organe élastique, ledit organe élastique comprenant plusieurs lames élastiques 14, 24 réparties, de préférence uniformément, autour du moyeu 12, 22, comme illustré à la figure 1. Dans cet exemple chaque unité 10, 20 comprend trois lames élastiques 14, 24.

La serge 13, 23 de chaque unité 10, 20 du dispositif 1 est en forme de cercle fermé et est guidée en rotation autour de son centre par rapport à son moyeu 12, 22 par l'ensemble des lames élastiques 14, 24. La serge 13, 23 peut également être interrompue et prendre la forme d'un ou plusieurs arc(s) de cercle.

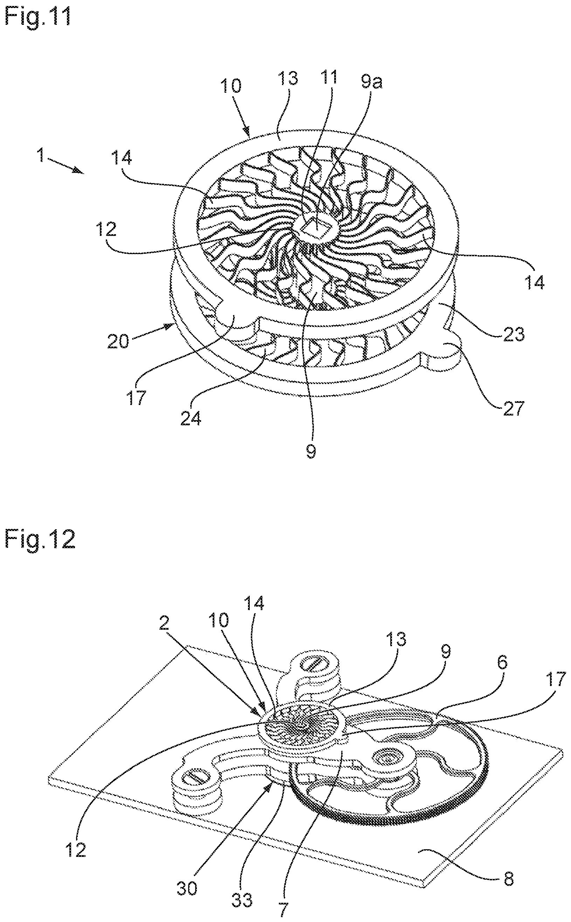

Les moyeux 12, 22 des deux unités 10, 20 du dispositif 1 sont solidaires en rotation. Dans l'exemple illustré à la figure 1, les moyeux 12, 22 sont rendus solidaires l'un de l'autre par l'insertion de goupilles 4 dans des trous 11 des moyeux 12, 22. Les moyeux 12, 22 des deux unités 10, 20 peuvent être rendus solidaires en rotation l'un de l'autre par tout autre moyen convenable, par exemple par la réalisation d'une structure monolithique ou par le biais d'un axe 9 comprenant des formations d'entraînement 9a non circulaires coopérant avec des trous 11 de formes correspondantes dans les moyeux 12, 22 (*cf.* figure 11), l'axe 9 pouvant, en variante, être monolithique avec les moyeux 12, 22.

Les serges 13, 23 des deux unités 10, 20 sont également solidaires en rotation. Dans l'exemple illustré à la figure 1, les serges 13, 23 du dispositif 1 sont rendues solidaires en rotation l'une de l'autre par l'insertion de goupilles 3 dans des ouvertures 15, 25 oblongues desdites serges 13, 23. Les ouvertures 15, 25 pourraient ne pas être oblongues, cette forme ayant uniquement pour but de compenser les défauts de localisation éventuels des ouvertures 15, 25 dans les pièces lors de leur fabrication. Il est possible d'avoir des ouvertures 15, 25 de formes différentes, typiquement rondes si la précision d'usinage est parfaite. Les serges 13, 23 des deux unités 10, 20 peuvent être rendues solidaires en rotation l'une de l'autre par tout autre moyen convenable. En particulier, dans le cas où la solidarité en rotation des moyeux 12, 22 des deux unités 10, 20 n'est pas obtenue par le biais de la réalisation d'une structure monolithique, la solidarité en rotation des serges 13, 23 des deux unités 10, 20 peut être obtenue par le biais de la réalisation d'une structure monolithique reliant directement les serges 13, 23 et vice-versa.

Dans le cadre du premier mode de réalisation de l'invention, les deux unités 10, 20 sont identiques (en particulier les lames 14, 24 ont la même forme).

Pour la compréhension de l'invention, le comportement de chaque unité 10, 20 du dispositif 1, considérée isolément, c'est-à-dire libre de toute interaction avec l'autre unité, est décrit ci-dessous. La figure 2 représente l'unité 10 isolée.

L'unité 10 isolée représentée à la figure 2 présente, en raison de la forme de ses lames élastiques 14, un sens de rotation privilégié de sa serge 13 par rapport à son moyeu 12, ce sens étant défini comme celui qui permet, à partir de son état de repos, le plus grand déplacement angulaire relatif de sa serge 13 par rapport à son moyeu 12. La flèche A représentée sur la figure 2, illustre le sens de rotation privilégié (sens anti-horaire) de la serge 13 de l'unité 10 par rapport à son moyeu 12. Au sein du dispositif 1 représenté à la figure 1, les unités 10, 20 sont placées tête-bêche, leurs sens de rotation privilégiés, représentés respectivement par les flèches A et B de la figure 1, sont donc opposés.

L'unité 10 isolée peut être armée par rotation de sa serge 13 par rapport à son moyeu 12 d'un angle $\theta_{10}$ dans son sens de rotation privilégié (*cf.* flèche A), l'angle $\theta_{10} = 0°$ correspondant à la position de repos de l'unité 10 isolée, c'est-à-dire à la position dans laquelle toutes ses lames élastiques 14 sont au repos (n'exercent aucun moment de rappel élastique). Lors d'un tel armage, les lames élastiques 14 de cette unité 10 se déforment pour exercer, dans l'unité 10 armée, un moment de rappel $M_{10}(\theta_{10})$ dépendant de la position $\theta_{10}$, tendant à faire pivoter la serge 13 par rapport au moyeu 12 dans le sens opposé au sens d'armage, c'est-à-dire dans le sens opposé au sens de rotation privilégié de l'unité 10, tendant ainsi à la faire revenir à son état de repos. Le moment de rappel élastique exercé par l'unité 20 est désigné par $M_{20}$. L'angle $\theta$, pour chaque unité 10, 20 isolée, respectivement $\theta_{10}$ et $\theta_{20}$, est un angle de déplacement de la serge 13, 23 par rapport au moyeu 12, 22 dans son sens de rotation privilégié.

Lorsque la serge 13, 23 d'une unité 10, 20 est dans la position angulaire dans laquelle l'angle $\theta$ associé à cette unité est égal à x°, on dit que l'unité 10, 20 ou l'ensemble des lames élastiques 14, 24 de l'unité 10, 20 est armé(e) de x°.

L'ensemble des lames élastiques 14 de l'unité 10 du dispositif 1 est conçu, notamment de par sa forme, pour exercer, dans cette unité 10, un moment de rappel élastique $M_{10}(\theta_{10})$ sensiblement constant sur une plage de positions angulaires $[\theta_{10min}, \theta_{10max}]$ de la serge 13 de ladite unité 10 par rapport à son moyeu 12 d'au moins 10°, de préférence d'au moins 15°, de préférence d'au moins 20°, de préférence d'au moins 25°.

On entend par moment « sensiblement constant » un moment ne variant pas de plus de 10%, de préférence 5%, de préférence encore 3%, typiquement 1,5% étant entendu que ce pourcentage peut être diminué davantage.

Plus précisément, soient respectivement $M_{10min}$ et $M_{10max}$ les valeurs des moments minimum et maximum exercés dans l'unité 10 isolée sur une plage donnée de positions angulaires de sa serge 13 par rapport à son moyeu 12, le moment exercé dans cette unité 10 est sensiblement constant dès lors que l'inéquation « $(M_{10max}-M_{10min})/((M_{10max}+M_{10min})/2) \leq 0,1$ » est vérifiée, plus précisément, dès lors que l'inéquation « $(M_{10max}-M_{10min})/((M_{10max}+M_{10min})/2) \leq y\%$ », avec y=10, de préférence 5, de préférence encore 3, par exemple 1,5, est vérifiée.

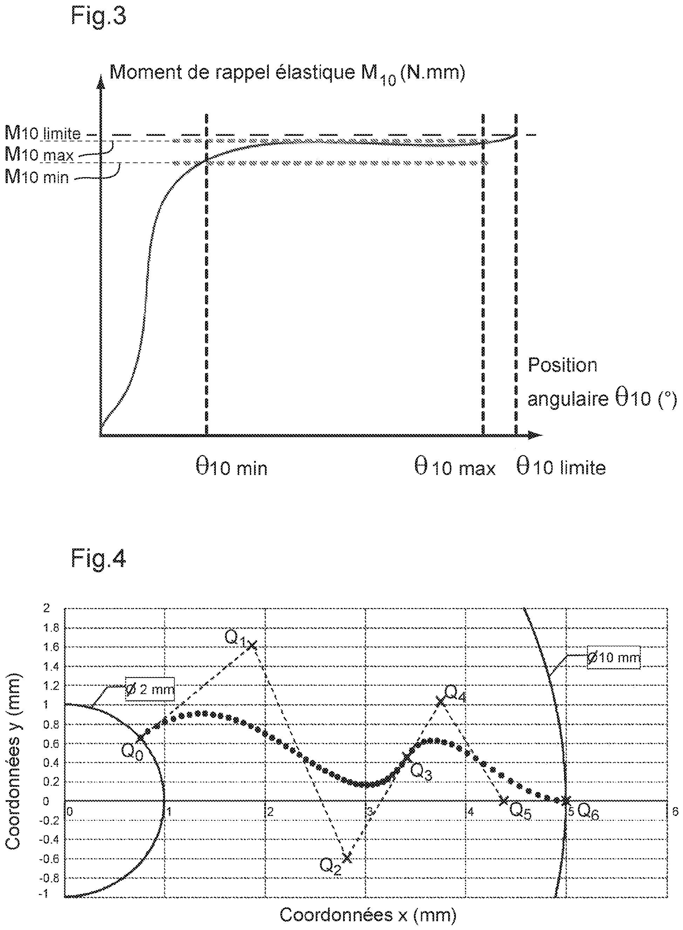

La figure 3 illustre schématiquement l'allure de la courbe d'évolution $M_{10}(\theta_{10})$ du moment $M_{10}$ de rappel élastique exercé par l'ensemble des lames élastiques 14 dans l'unité 10 isolée en fonction de la position angulaire $\theta_{10}$ relative de sa serge 13 par rapport à son moyeu 12, cette position angulaire relative correspondant à l'angle $\theta_{10}$ défini précédemment.

Comme cela est visible sur la courbe $M_{10}(\theta_{10})$ de la figure 3, le moment de rappel élastique de l'unité 10 isolée représentée à la figure 2 suit globalement une évolution en trois phases :

- pour un angle $\theta_{10}$ compris entre 0 et une première valeur $\theta_{10min}$, le moment de rappel élastique augmente rapidement avec le déplacement angulaire $\theta_{10}$, cette phase correspond à la phase d'armage ;
- au-delà de cette première valeur $\theta_{10min}$, l'unité 10 est dans une phase stable. En effet, entre cette première valeur $\theta_{10min}$ et une seconde valeur $\theta_{10max}$, le moment de rappel élastique est sensiblement constant par rapport au déplacement angulaire $\theta_{10}$ ;
- au-delà de cette deuxième valeur $\theta_{10max}$, le moment de rappel élastique augmente à nouveau jusqu'à atteindre une valeur limite $M_{10limite}$, pour un déplacement angulaire $\theta_{10}=\theta_{10limite}$. Cette valeur $M_{10limite}$ dépend des propriétés du matériau dans lequel l'unité est réalisée et est atteinte lorsque l'unité 10 subit la contrainte maximale qu'elle peut supporter.

Pour une unité monolithique donnée, il est possible de définir des valeurs limites d'angles $\theta_{min\_y\%}$ et $\theta_{max\_y\%}$ entre lesquelles le moment de rappel élastique est sensiblement constant, avec une constance de y%. Par exemple, si l'on veut obtenir une constance du moment de rappel élastique de 5%, on définit à l'aide de la courbe M($\theta$) associée à cette unité, les valeurs des angles $\theta_{min\_5\%}$ et $\theta_{max\_5\%}$ pour que l'inéquation : « $(M_{max}-M_{min})/((Mmax+Mmin)/2) < 0,05$ » soit vérifiée ; avec Mmax le moment de rappel élastique maximum de cette unité sur l'intervalle d'angles [$\theta_{min\_5\%}$, $\theta_{max\_5\%}$] et Mmin le moment de rappel élastique minimum de cette unité sur ce même intervalle.

Chaque unité possède donc, pour un pourcentage "y" donné de constance du moment de rappel élastique, une plage de positions angulaires [$\theta_{min\_y\%}$, $\theta_{max\_y\%}$] qui lui est propre, dans laquelle elle exerce un moment de force sensiblement constant. Dans le premier mode de réalisation de l'invention, les deux unités 10, 20 étant identiques, on a [$\theta_{10min\_y\%}$, $\theta_{10max\_y\%}$] = [$\theta_{20min\_y\%}$, $\theta_{20max\_y\%}$].

Comme déjà indiqué, les deux unités 10, 20 sont agencées tête-bêche de sorte que leurs sens de rotation privilégiés respectifs sont opposés. Chacune des unités 10 et 20 est armée dans son sens de rotation privilégié et exerce donc un moment de rappel élastique, respectivement $M_{10}(\theta_{10})$ et $M_{20}(\theta_{20})$, opposé à celui exercé par l'autre desdites unités 10, 20. Le dispositif 1 est conçu de sorte que, lorsqu'il est au repos, c'est-à-dire lorsqu'aucune force extérieure ne s'exerce sur lui, et notamment lorsqu'aucune force extérieure ne tend à engendrer une rotation de ses serges 13, 23 par rapport à ses moyeux 12, 22, chacune de ses deux unités 10 et 20 est armée d'une valeur respectivement $\theta_{10arm}$ et $\theta_{20arm}$, avec $\theta_{10arm}$ inclus dans la plage [$\theta_{10min}$, $\theta_{10max}$] et $\theta_{20arm}$ inclus dans la plage [$\theta_{20min}$, $\theta_{20max}$]. On dit alors que chacune des unités 10, 20 est pré-armée, respectivement de $\theta_{10arm}$ et de $\theta_{20arm}$. Dans le cadre du premier mode de réalisation de l'invention, les deux unités 10, 20 identiques sont typiquement pré-armées de la même valeur $\theta_{arm}$. Le dispositif 1 est alors dans une position dite « d'équilibre d'armage » dans laquelle les moments de rappel $M_{10}(\theta_{arm})$, $M_{20}(\theta_{arm})$ respectivement exercés par les organes élastiques 14, 24 des unités 10, 20 se compensent théoriquement parfaitement : $M_{10}(\theta_{arm})= - M_{20}(\theta_{arm})$.

Lors de son utilisation, le dispositif 1 est destiné à être fixé soit par une partie solidaire en rotation de ses serges 13, 23, soit par une partie solidaire en rotation de ses moyeux 12, 22, à un support fixe ou mobile, tel qu'une platine, un pont ou une cage de tourbillon d'un mécanisme horloger, de sorte que les serges 13, 23 ou les moyeux 12, 22 des unités 10, 20 sont fixes par rapport audit support pendant l'utilisation du dispositif 1. Les autres de ces éléments sont quant à eux mobiles en rotation par rapport auxdits éléments fixes.

Dans la suite de la description, on utilise l'expression « élément mobile » pour désigner celui de l'ensemble comprenant les moyeux 12, 22 du dispositif 1 ou de l'ensemble comprenant les serges 13, 23 du dispositif qui est mobile en rotation par rapport audit support lors de l'utilisation du dispositif 1, l'autre étant désigné par l'expression « élément fixe ».

Les unités monolithiques présentant une courbe M($\theta$) du type de celle représentée à la figure 3 diffèrent des structures élastiques classiques. Leurs propriétés reposent sur une forme sinueuse de leurs lames élastiques qui se déforment de manière à générer un moment de rappel élastique sensiblement constant (la courbe M(θ) présente un plateau). L'obtention de telles lames élastiques requiert une conception spécifique et paramétrée. Elles peuvent par exemple être obtenues par optimisation topologique en appliquant l'enseignement de la publication « Design of adjustable constant-force forceps for robot-assisted surgical manipulation », Chao-Chieh Lan et al., 2011 - IEEE International Conference on robotics and automation Shanghai International Conference Center May 9-13, China.

L'optimisation topologique dont il est question dans l'article précité utilise des courbes polynomiales paramétriques telles que les courbes de Bézier pour déterminer la forme géométrique des lames élastiques.

Les courbes de Bézier se définissent, conjointement à une série de $m=(n+1)$ points de contrôle $(Q_0, Q_1, ... Q_n)$, par un ensemble de points dont les coordonnées sont données par des sommes de polynômes de Bernstein pondérées par les coordonnées desdits points de contrôle.

La forme géométrique de chacune des lames élastiques du dispositif est une courbe de Bézier dont les points de contrôle ont été optimisés pour prendre en compte, notamment, les dimensions de l'unité à concevoir ainsi que la contrainte « (Mmax-Mmin)/((Mmax+Mmin)/2) ≤ 0,05 » recherchée. L'inéquation « $(M_{max}-M_{min})/((M_{max}+M_{min})/2) \leq 0,05$ » correspond à une constance du moment de rappel élastique de 5% sur une plage angulaire $[\theta_{min\_5\%}, \theta_{max\_5\%}]$.

Plus précisément, la forme géométrique de chacune des lames élastiques du dispositif est définie par l'ensemble des points

$$\sum_{i=0}^{n} B_i^n(t).Q_i, \text{ avec } t \in [0, 1],$$

où les $B_i^n$ sont les polynômes de Bernstein donnés par la fonction

$$B_i(t) = \frac{(m-1)!}{i!(m-1-i)!} t^i (1-t)^{m-i-1} \text{ avec } t \in [0, 1],$$

et où les $Q_i$ sont les points de contrôle $Q_0$ à Qn. Elle correspond à la représentation graphique dans un repère orthonormé de l'ensemble des points définis par les couples de coordonnées (x ; y) définis respectivement par les fonctions x(t) et y(t), $t \in [0, 1]$, ci-dessous :

$$x(t) = \sum_{i=0}^{m-1} Q_{ix} B_i(t)$$

$$y(t) = \sum_{i=0}^{m-1} Q_{iy} B_i(t)$$

dans lesquelles $Q_{ix}$ et $Q_{iy}$ sont respectivement les coordonnées x et y des points de contrôle $Q_i$.

Les formules indiquées ci-dessus donnent les coordonnées d'une courbe de Bézier d'ordre m, c'est-à-dire une courbe de Bézier basée sur m points de contrôle. Pour des raisons pratiques, une telle courbe de Bézier peut être décomposée en une succession de courbes de Bézier d'ordre inférieur à m, auquel cas la forme géométrique de chacun des bras élastiques est une succession de courbes de Bézier.

En utilisant ce principe, la demanderesse a conçu une unité particulière comprenant trois lames élastiques réparties uniformément autour du moyeu. Cette unité particulière correspond à l'unité 10 représentée dans les figures. Les dimensions de cette unité 10 sont les suivantes :

| | |
|---|---|
| Diamètre extérieur de la serge : | 12 mm |
| Diamètre extérieur du moyeu : | 2 mm |
| Diamètre intérieur de la serge : | 10 mm |
| Hauteur: | 0,12 mm |
| Epaisseur des lames élastiques : | 80 μm |
| Longueur curviligne de chaque lame: | 4,91 mm |

Dans le cadre de cette conception, sept points de contrôle $Q_0$, $Q_1$, $Q_2$, $Q_3$, $Q_4$, $Q_5$, $Q_6$ ont été utilisés. Les coordonnées de ces points de contrôle sont indiquées dans le tableau 1 ci-dessous.

*Tableau 1 : Coordonnées des points de contrôle $Q_0$ à $Q_6$.*

| Variables | Coordonnées x [mm] | Coordonnées y [mm] |
|---|---|---|
| $Q_0$ | 0,756625 | 0,653875 |
| $Q_1$ | 1,87325 | 1,619 |
| $Q_2$ | 2,8125 | -0,59125 |
| $Q_3$ | 3,4375 | 0,4535 |
| $Q_4$ | 3,75 | 1,032875 |
| $Q_5$ | 4,375 | 0 |
| $Q_6$ | 5 | 0 |

Avec ces sept points de contrôle il aurait été possible de réaliser une courbe de Bézier d'ordre sept. Cependant, selon le principe indiqué ci-dessus, la courbe de Bézier a été décomposée en deux segments, un premier segment correspondant à une courbe de Bézier d'ordre 4 basée sur les points de contrôle $Q_0$ à $Q_3$ et un second segment correspondant à une courbe de Bézier d'ordre 4 basée sur les points de contrôle $Q_3$ à $Q_6$.

En utilisant les coordonnées des points de contrôle $Q_0$ à $Q_6$ ci-dessus dans les fonctions x(t) et y(t) précitées, la demanderesse a obtenu les coordonnées des points définissant la forme géométrique d'une lame élastique de l'unité 10. Un certain nombre de ces couples de coordonnées sont donnés dans le tableau 2 ci-après.

*Tableau 2 : Coordonnées de points de passage de la lame élastique optimisée*

| x [mm] | y [mm] |
|---|---|
| 0,756625 | 0,653875 |
| 1,086132 | 0,854582 |
| 1,404044 | 0,903348 |
| 1,709407 | 0,838756 |
| 2,001267 | 0,699389 |
| 2,278672 | 0,523828 |
| 2,540668 | 0,350656 |
| 2,786302 | 0,218455 |
| 3,014621 | 0,165807 |
| 3,224671 | 0,231295 |
| 3,4155 | 0,4535 |
| 3,524275 | 0,58159 |
| 3,648736 | 0,628816 |
| 3,787142 | 0,611048 |
| 3,937748 | 0,544158 |
| 4,098813 | 0,444016 |
| 4,268592 | 0,326492 |
| 4,445344 | 0,207458 |
| 4,627324 | 0,102784 |
| 4,812791 | 0,028341 |
| 5 | 0 |

Le graphique de la figure 4 fait apparaître la géométrie du diamètre externe du moyeu, du diamètre interne de la serge et d'une des lames élastiques de l'unité 10 que la demanderesse a conçue, la géométrie de ladite lame étant définie par une courbe passant par l'ensemble des coordonnées de points défini dans le tableau 2 ci-dessus. Ce graphique est réalisé dans un repère orthonormé.

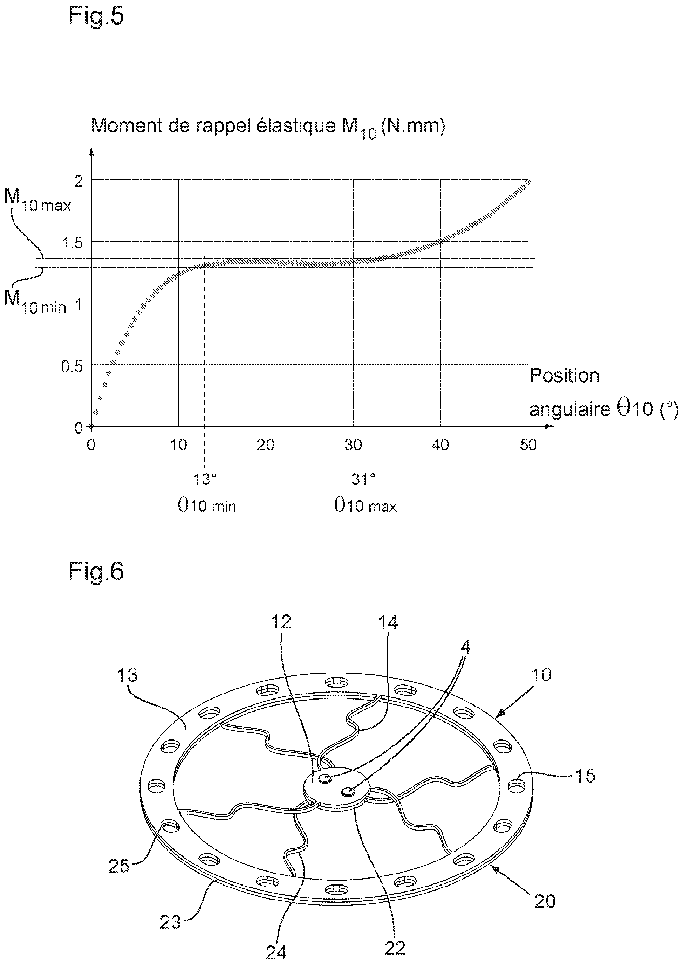

La figure 5 représente les résultats d'une simulation de l'évolution du moment de rappel élastique de l'unité 10 isolée ainsi réalisée en fonction de la position angulaire $\theta_{10}$ de sa serge par rapport à son moyeu.

La simulation effectuée considère l'unité 10 isolée réalisée en verre métallique mais tout matériau approprié peut être utilisé. Par exemple des matériaux tels que le silicium typiquement revêtu d'oxyde de silicium, le Nivaflex® 45/18 (alliage à base de cobalt, nickel et chrome) ; le plastique ou le CK101 (acier de construction non-allié) conviennent également et permettent l'obtention d'unités monolithiques dont le moment de rappel élastique est sensiblement constant sur les mêmes plages angulaires $[\theta_{min}, \theta_{max}]$.

La plage angulaire de fonctionnement permettant la délivrance d'un moment sensiblement constant étant une constante liée à la forme des lames élastiques. L'angle de fonctionnement $\theta_{10max}$ doit être inférieur à l'angle $\theta_{10lim}$ correspondant à la limite avant plastification ou rupture de l'unité 10. Cela permet de définir l'épaisseur maximale qu'il est possible de réaliser sur les lames.

Il ressort de l'analyse des résultats présentés à la figure 5 qu'une constance de 2,4% du moment de rappel élastique est obtenue pour un déplacement angulaire de la serge 13 de l'unité 10 étudiée par rapport à son moyeu 12 compris entre $\theta_{min\_2,4\%}$, soit 13°, et $\theta_{max-2,4\%}$, soit 31°, soit sur une plage de fonctionnement de 18°. L'unité 10 ainsi réalisée possède donc une plage de fonctionnement à moment constant (pour une constance de 2,4%), qui lui est propre, de 18°. Si l'on accepte une constance de 9,1% du moment de rappel élastique alors l'unité 10 ainsi réalisée possède une plage de fonctionnement à moment constant qui lui est propre d'environ 23°, avec $\theta_{10min\_9,1\%} \approx 10,5°$ et $\theta_{10max\_9,1\%} \approx 33,5°$.

Le tableau 3 ci-dessous donne, à titre indicatif, les valeurs $\theta_{10min\_y\%}$, $\theta_{10max\_y\%}$ et $\Delta\theta_{10}$ (plage de positions angulaires à moment sensiblement constant) associées à l'unité 10 réalisée par la demanderesse en fonction du pourcentage de constance **y** considéré ainsi que les valeurs de moments de force $M_{10min}$ et $M_{10max}$ associées.

*Tableau 3 :*

| $\theta_{min\_y\%}$ | $\theta_{max\_y\%}$ | Plage angulaire $\Delta\theta$ (°) | Mmin | Mmax | Pourcentage de constance y (%) |
|---|---|---|---|---|---|
| 13,5 | 30,5 | 17 | 1,310 | 1,331 | 1,6 |
| 13 | 31 | 18 | 1,303 | 1,335 | 2,4 |
| 12,5 | 31,5 | 19 | 1,294 | 1,339 | 3,4 |
| 12 | 32 | 20 | 1,284 | 1,343 | 4,5 |
| 10,5 | 33,5 | 23 | 1,242 | 1,360 | 9,1 |

En augmentant le nombre de points de contrôle lors de la conception des lames élastiques, on devrait pouvoir augmenter la précision de la forme de ces lames élastiques et améliorer ainsi la constance du moment de rappel.

Afin d'obtenir un dispositif 1 tel que représenté à la figure 1 :

a) deux unités monolithiques 10, 20 identiques à l'unité 10 développée par la demanderesse ont été réalisées, le moyeu 12, 22 de chacune de ces unités 10, 20 comprenant des trous 11 ;

b) ces unités 10, 20 ont été superposées, tête-bêche ;

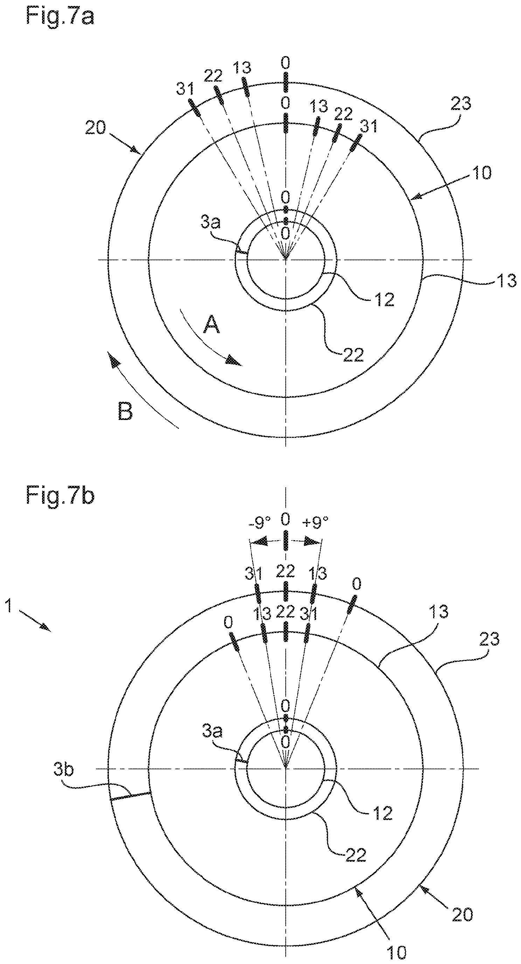

c) les moyeux 12, 22 des unités 10, 20 ont ensuite été rendus solidaires l'un de l'autre par introduction de goupilles 4 dans leurs trous 11. Le dispositif intermédiaire ainsi obtenu est représenté à la figure 6. La figure 7a illustre schématiquement ce même dispositif. Dans cette figure, pour des raisons pratiques, la serge 23 de l'unité 20 est représentée plus grande que celle 13 de l'unité 10, le moyeu 22 de l'unité 20 est représenté plus grand que celui 12 de l'unité 10 et les lames élastiques 14, 24 ne sont pas représentées. Dans cette figure 7a, des repères « 0 » alignés respectivement sur les serges 13, 23 et sur les moyeux 12, 22 des unités 10 et 20 servent d'index pour repérer l'état de repos de chacune des unités : $\theta_{10} = \theta_{20} = 0°$. La solidarisation des moyeux 12, 22 est représentée schématiquement par un segment 3a reliant les moyeux 12, 22.

d) chacune des deux unités 10, 20 a ensuite été armée d'un même angle $\theta_{arm}$ dans son sens de rotation privilégié, sens anti-horaire pour l'unité 10 (flèche A) et sens horaire pour l'unité 20 (flèche B). Dans l'exemple illustré, pour chacune des unités 10, 20 : $\theta_{min} = 13°$, $\theta_{max} = 31°$ et $\theta_{arm} = 22°$. Pour faciliter l'armage, les moyeux 12, 22 ont été maintenus en position fixe lors de la rotation respectivement dans les sens anti-horaire et horaire des serges 13, 23 des unités 10, 20.

e) une fois armées, les serges 13, 23 ont été rendues solidaires en rotation l'une de l'autre par insertion de goupilles 3 dans leurs ouvertures 15, 25. Les figures 1 et 7b illustrent le dispositif 1 ainsi obtenu. Dans la figure 7b, la solidarisation des serges 13, 23 est représentée schématiquement par un segment 3b reliant les serges 13, 23. Dans cette position d'équilibre d'armage, chacune des unités 10, 20 exerce un moment de rappel élastique tendant à faire pivoter l'ensemble comprenant les serges 13, 23 par rapport à l'ensemble comprenant les moyeux 12, 22 de même valeur $M_{20}(22°) = - M_{10}(22°) = 1,3$ N.mm, les sens de ces moments de rappel élastiques étant opposés.

Il apparaît clairement à l'homme du métier qu'un dispositif 1 selon le premier mode de réalisation de l'invention peut être obtenu par une succession d'étapes différente.

Considérons le dispositif 1 tel que décrit ci-dessus dans lequel l'ensemble comprenant les serges 13, 23 est l'élément fixe. L'élément mobile correspond donc à l'ensemble comprenant les moyeux 12, 22.

Soit $\alpha$ la position angulaire de l'élément mobile, à savoir l'ensemble comprenant les moyeux 12, 22, par rapport à l'élément fixe, $\alpha$ étant égal à zéro dans la position d'équilibre d'armage et augmentant lors de la rotation dans le sens horaire de l'élément mobile.

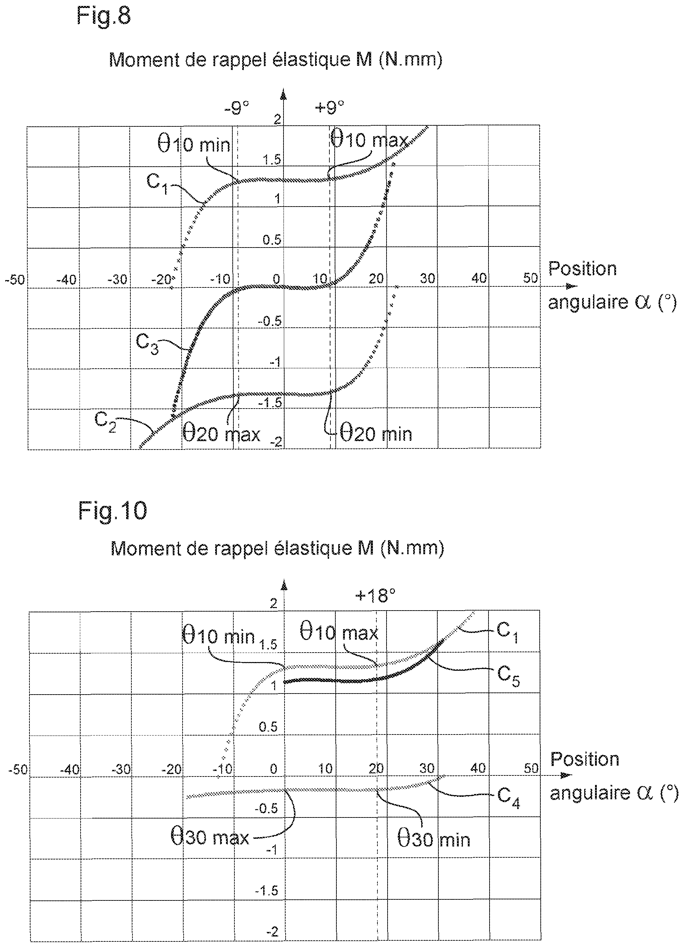

La courbe $C_1$ de la figure 8 correspond à la courbe $M_{10}(\alpha)$ de l'unité 10 et la courbe $C_2$ de la figure 8 correspond à la courbe $M_{20}(\alpha)$ de l'unité 20. Un moment de rappel positif correspond à un moment tendant à faire pivoter l'ensemble comprenant les moyeux 12, 22 dans le sens anti-horaire.

La courbe $C_1$ correspond à la courbe $M_{10}(\theta_{10})$ que l'on aurait pour l'unité 10 isolée et qui aurait subi, du fait de la phase d'armage, une translation de a = $\theta_{10arm}$ = 22° vers la gauche. En effet, l'unité 10 est placée de sorte que l'augmentation de l'angle a, à partir de $\alpha = - (\theta_{10arm}) = - 22°$, correspond à une rotation de sa serge 13 relativement à son moyeu 12 dans son sens de rotation privilégié. En effet, lorsque la serge 13 est fixe et que le moyeu 12 pivote dans le sens horaire, la serge 13 se déplace dans le sens anti-horaire relativement au moyeu 12. Le moment de force $M_{10}$ exercé par l'unité 10 tend à faire pivoter le moyeu 12, et donc l'élément mobile, dans le sens anti-horaire et est donc positif.

La courbe $C_2$ correspond à la symétrique de la courbe $M_{20}(\theta_{20})$ que l'on aurait pour l'unité 20 isolée par rapport au centre du repère et qui aurait subi une translation de $\alpha = \theta_{20arm}$ = 22° vers la droite. En effet, l'unité 20 est placée de sorte que la diminution de l'angle a, à partir de $\alpha = \theta_{20arm}$ = 22°, correspond à une rotation de sa serge 23 relativement à son moyeu 22 rapport dans son sens de rotation privilégié. En effet, lorsque la serge 23 est fixe et que le moyeu 22 pivote dans le sens anti-horaire, la serge 23 se déplace dans le sens horaire relativement au moyeu 22. Le moment de force $M_{20}$ exercé par l'unité 20 tend à faire pivoter le moyeu 22, et donc l'élément mobile, dans le sens horaire et est donc négatif.

La courbe $C_3$ de la figure 8 illustre le moment de rappel $M(\alpha)$ s'exerçant sur l'élément mobile en fonction de sa position angulaire a. Cette courbe correspond à la somme des courbes $C_1$ et $C_2$.

Pour réaliser cette simulation, l'ensemble comprenant les serges 13, 23 du dispositif 1 a été immobilisé et le moment nécessaire pour maintenir l'ensemble comprenant les moyeux 12, 22 en position a été mesuré pour une plage de positions angulaires a.

Comme cela est visible sur la figure 8, tant que la position $\alpha$ est telle que l'armage de chacune des deux unités 10, 20 reste dans la plage de valeur [$\theta_{min}$, $\theta_{max}$] qui lui est associée, en l'espèce, tant que l'armage de chacune des deux unités reste dans la plage de valeurs [13°, 31°] qui lui est associée, les moments de rappel exercés par les deux unités 10, 20 sur l'élément mobile se compensent presque complètement. Ainsi, le moment de rappel résultant sur l'élément mobile est quasiment nul. Cela correspond à une plage de positions angulaire prédéterminée $\alpha$ de l'élément mobile par rapport à l'élément fixe allant de $\alpha$ = -9° à $\alpha$ = 9°, soit une plage angulaire prédéterminée de 18°. Ainsi, la plage de positions angulaires prédéterminée du dispositif 1 selon l'invention correspond à la plage de chevauchement des plages [$\theta_{10min}$, $\theta_{10max}$] et [$\theta_{20min}$, $\theta_{20max}$].

Si l'on entraîne l'élément mobile en rotation au-delà de $\alpha$ = 9°, la courbe $C_3$ monte ce qui signifie que le moment de rappel élastique $M(\alpha)$ global tend à faire pivoter l'ensemble comprenant les moyeux 12, 22 dans le sens anti-horaire.

Dans le cas étudié, pour chaque unité 10, 20, $\theta_{10arm}$, $\theta_{20arm}$ est centré sur la plage [$\theta_{min}$, $\theta_{max}$] associée à cette unité 10, 20. Ainsi, on obtient la plage de positions angulaire prédéterminée la plus étendue possible et un dispositif 1 de guidage « bidirectionnel à partir de sa position de repos », l'élément mobile pouvant, à partir de sa position de repos, être entraîné en rotation dans le sens horaire de 9° (jusqu'à $\alpha$ = 9°) et dans le sens anti-horaire de 9° (jusqu'à $\alpha$ = -9°) en subissant un moment de rappel élastique sensiblement nul.

Pour comparaison, si l'on avait armé chacune des unités 10, 20 du dispositif précédemment décrit d'une même valeur $\theta_{arm}$ = 15°, la plage angulaire prédéterminée de positions aurait été de 4°, et si l'on avait armé l'unité 10 du dispositif précédemment décrit d'une valeur $\theta_{10arm}$ = 13° et l'unité 20 du dispositif précédemment décrit d'une valeur $\theta_{20arm}$ = 31°, la plage angulaire prédéterminée de positions aurait été de 18° mais le dispositif de guidage aurait été « unidirectionnel à partir de sa position de repos », l'élément mobile pouvant, à partir de sa position de repos, être entraîné en rotation dans le sens horaire de 18° (jusqu'à $\alpha$ = 18°) en subissant un moment de rappel élastique sensiblement nul.

Dans le dispositif 1 selon le premier mode de réalisation de l'invention, pour chaque unité 10, 20, $\theta_{arm}$ est de

préférence centré sur la plage de positions angulaires [$\theta_{min}$, $\theta_{max}$] qui lui est associée. Il est donc de préférence égal à ($\theta_{min}$ + (($\theta_{max}$-$\theta_{min}$)/2)), de sorte que [$\theta_{min}$, $\theta_{arm}$] = [$\theta_{arm}$, $\theta_{max}$]. De cette façon, les unités 10, 20 exercent des moments de rappel $M_{10}(\theta_{10})$, $M_{20}(\theta_{20})$ se compensant presque totalement sur une plage de positions angulaires prédéterminée des serges 13, 23 par rapport aux moyeux 12, 22 s'étendant de $\theta_{min}$ à $\theta_{max}$ et pour une rotation $\alpha$ de l'élément mobile aussi bien dans le sens horaire que dans le sens anti-horaire.

Sur une plage angulaire prédéterminée de rotation de l'élément mobile par rapport à l'élément fixe, cette plage dépendant notamment des valeurs de pré-armage de chacune des unités 10, 20, les organes élastiques 14, 24 des unités 10, 20 exercent sur ledit élément mobile des moments de rappel élastique se compensant partiellement voire totalement.

Des butées et protubérances peuvent être aménagées pour limiter la rotation de l'élément mobile à cette plage angulaire prédéterminée.

La figure 11 illustre une variante du dispositif représenté à la figure 1 dans laquelle les moyeux 12, 22 des deux unités 10, 20 sont rendus solidaires en rotation l'un de l'autre par le biais d'un axe 9 comprenant des formations d'entraînement 9a non circulaires coopérant avec des trous 11 de formes correspondantes dans les moyeux 12, 22. Chacune des serges 13, 23 des unités 10, 20 possède une protubérance 17, 27 servant d'index pour l'armage des unités 10, 20.

Un dispositif 1 selon le premier mode de réalisation de l'invention peut par exemple être utilisé pour guider en rotation un composant horloger tel qu'une ancre d'échappement, une bascule ou un levier dans un mécanisme horloger. L'axe 9 peut alors avantageusement porter le composant horloger à faire tourner.

Une ancre d'échappement pourrait par exemple être guidée en rotation au sein d'un mécanisme horloger par un dispositif 1 tel que représenté à la figure 11. Pour cela, l'ancre pourrait être chassée sur l'axe 9 de façon à être rendue solidaire en rotation des moyeux 12, 22. L'axe 9 serait alors l'axe de rotation de l'ancre. L'ancre d'échappement serait typiquement placée entre les deux unités 10, 20 dont les serges 13, 23 seraient respectivement solidaires d'un pont et de la platine du mécanisme horloger.

Une ancre d'échappement guidée par un dispositif 1 utilisant deux unités 10, 20 identiques à l'unité 10 réalisée par la demanderesse avec une valeur d'armage initiale de chaque unité de 22° pourrait donc théoriquement pivoter sur un angle de 18° sans frottement et avec un moment de rappel négligeable, tout en gardant une raideur importante en dehors de son plan de pivotement.

Un dispositif 1 selon le premier mode de réalisation de l'invention peut également être utilisé pour le guidage de tout composant que l'on cherche à guider en rotation sans frottement et avec un moment de rappel le plus faible possible.

En variante, il est envisageable de réaliser un dispositif selon le premier mode de réalisation de l'invention comprenant des unités monolithiques différentes l'une de l'autre (typiquement dont la taille, le nombre, la forme et/ou la matière des lames élastiques est différente entre l'une et l'autre), chacune desdites unités étant agencée au sein du dispositif pour exercer un moment de rappel élastique sensiblement constant sur une plage prédéterminée de positions angulaires de sa serge par rapport à son moyeu, la valeur de ce moment sensiblement constant étant sensiblement la même pour les deux unités. En d'autres termes, les « plateaux » des courbes M($\theta$) de chacune des unités correspondent à des valeurs de moment de rappel élastique sensiblement identiques. Dans cette variante, il est possible d'avoir des plages [$\theta_{min}$, $\theta_{max}$] différentes d'une unité à l'autre.

Un dispositif 2 selon un second mode de réalisation de l'invention diffère du dispositif 1 selon le premier mode de réalisation en ce que ses deux unités ne sont pas identiques et présentent des courbes M($\theta$) dont les « plateaux » correspondent à des valeurs de moment de rappel élastique sensiblement différentes. Chacune des unités du dispositif 2 selon le second mode de réalisation de l'invention est apte à engendrer un moment de rappel sensiblement constant sur une plage de positions angulaires de sa serge par rapport à son moyeu qui lui est propre, ce moment de rappel s'exerçant dans un premier sens et étant sensiblement égal à une première valeur X pour une première des deux unités et s'exerçant dans un second sens opposé au premier et sensiblement égal à une seconde valeur Y, différente de X pour une seconde desdites unités.

Un tel dispositif 2 permet un guidage en rotation sans frottement, engendrant un moment de rappel élastique sensiblement constant environ égal à |X-Y|. Un tel dispositif 2 peut être préféré au dispositif selon le premier mode de réalisation de l'invention, par exemple lorsque l'on cherche à obtenir un dispositif de guidage sans frottement et avec un moment de rappel faible mais non sensiblement nul, par exemple pour le guidage d'un levier ou d'une bascule. Ledit levier ou bascule est par exemple une bascule d'embrayage de chronographe, un marteau, en particulier un marteau de chronographe, ou un bloqueur, en particulier un bloqueur de chronographe.

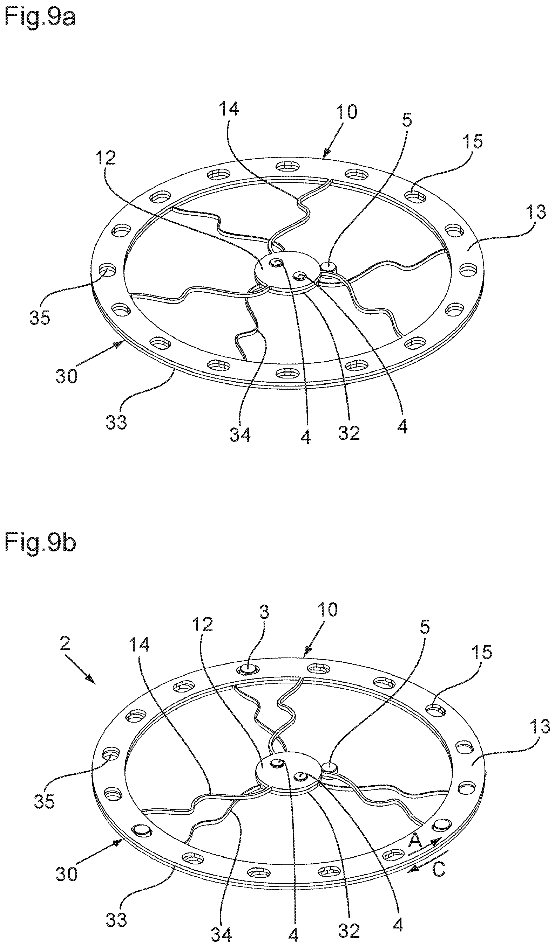

La figure 9b illustre un tel dispositif 2. La figure 9a illustre une étape de réalisation de ce dispositif, avant la phase d'armage.

Le dispositif 2 représenté à la figure 9b diffère du dispositif 1 représenté à la figure 1 en ce que ses deux unités 10, 30 ne sont pas identiques. Une première 10 de ses unités 10, 30 monolithiques est identique à l'unité 10 utilisée dans le dispositif 1 et l'autre unité 30 diffère de la première unité 10 en ce que ses trois lames élastiques 34 ne font que 40 $\mu$m d'épaisseur (contre 80 $\mu$m pour l'unité 10). L'unité 30 comprenant trois lames élastiques 34 possède des propriétés similaires à celle de l'unité 10 comprenant trois lames élastiques 14, elle comprend en particulier les mêmes valeurs $\theta_{min}$ et $\theta_{max}$ que l'unité 10. Cependant, ses propriétés diffèrent de celles de l'unité 10 en ce que la courbe $M_{30}(\alpha)$ associée (*cf.* courbe $C_4$ de la figure 10) présente un « plateau » (moment de rappel sensiblement constant) pour une valeur de moment de rappel élastique en valeur absolue inférieure à celle de l'unité 10.

Comme illustré aux figures 9a et 9b, l'unité 30 du dispositif 2 peut, comme l'unité 20 du dispositif 1, comprendre des ouvertures 35 permettant la solidarisation en rotation des serges 13 et 33 des unités 10 et 30.

Dans ce dispositif 2, l'unité 10 est légèrement armée de $\theta_{10arm} = \theta_{10min} = 13°$, par rotation de sa serge 13 par rapport à son moyeu 12 dans le sens anti-horaire, pour que son comportement soit à la limite inférieure de la zone constante (au début du « plateau ») ; l'unité 30 est, quant à elle, fortement armée de $\theta_{30arm} = \theta_{30max} = 31°$ par rotation de sa serge 33 par rapport à son moyeu 32 dans le sens horaire, pour que son comportement soit à la limite supérieure de la zone constante (à la fin du « plateau »).

Les sens de rotation privilégiés des unités 10, 30 du dispositif 2 sont représentés respectivement par les flèches A et C de la figure 9b.

Une butée 5 coopère avec une des lames élastiques 14, 34 ou avec une protubérance du moyeu 12, 32 et évite, dans le cas où l'élément mobile comprendrait les moyeux 12, 32, que cette unité 10 dont le moment de rappel associé est, en valeur absolue, le plus important, entraîne le moyeu 32 de l'unité 30 (dont le moment de rappel associé est moins important) dans le sens anti-horaire, ce qui reviendrait à l'armer au-delà de sa valeur $\theta_{30max}$.

Si le dispositif 2 était conçu pour que l'élément mobile comprenne les serges 13, 33 et non les moyeux 12, 32, la butée 5 serait agencée pour limiter la rotation des serges 13, 33.

Ce dispositif 2 est asymétrique et se comporte comme un ressort à force constante lors de la rotation de ses moyeux 12, 32 dans le sens horaire. Les figures 9a et 9b illustrent ce dispositif avant et après armage.

Considérons le dispositif 2 tel que décrit ci-dessus dans lequel l'ensemble comprenant les serges 13, 33 est fixe. L'élément mobile correspond donc à l'ensemble comprenant les moyeux 12, 32.

Soit $\alpha$ la position angulaire de l'élément mobile par rapport à l'élément fixe, $\alpha$ étant égal à zéro dans la position d'équilibre d'armage et augmentant lors de la rotation dans le sens horaire de l'élément mobile ;

La courbe $C_1$ de la figure 10 correspond à la courbe $M_{10}(\alpha)$ de l'unité 10 et la courbe $C_4$ de la figure 10 correspond à la courbe $M_{30}(\alpha)$ de l'unité 30. Un moment de rappel positif correspond à un moment tendant à faire pivoter l'ensemble comprenant les moyeux 12, 32 dans le sens anti-horaire.

La courbe $C_1$ correspond à la courbe $M_{10}(\theta_{10})$ que l'on aurait pour l'unité 10 isolée et qui aurait subi, du fait de la phase d'armage, une translation de $a = \theta_{10arm} = 13°$ vers la gauche. En effet, l'unité 10 est placée de sorte que l'augmentation de l'angle a, à partir de $\alpha = -\theta_{10arm} = -13°$, correspond à une rotation de sa serge 13 relativement à son moyeu 12 dans son sens de rotation privilégié. Le moment de force $M_{10}$ exercé par l'unité 10 tend à faire pivoter le moyeu 12, et donc l'élément mobile, dans le sens anti-horaire et est donc positif.

La courbe $C_4$ correspond à la symétrique de la courbe $M_{30}(\theta_{30})$ que l'on aurait pour l'unité 30 isolée par rapport au centre du repère et qui aurait subi une translation de $\alpha = \theta_{30arm} = 31°$ vers la droite. En effet, l'unité 30 est placée de sorte que la diminution de l'angle a, à partir de $\alpha = \theta_{30arm} = 31°$, correspond à une rotation de sa serge 33 relativement à son moyeu 32 rapport dans son sens de rotation privilégié. Le moment de force $M_{30}$ exercé par l'unité 30 tend à faire pivoter le moyeu 32, et donc l'élément mobile, dans le sens horaire et est donc négatif.

La courbe $C_5$ de la figure 10 illustre le moment de rappel $M(\alpha)$ s'exerçant sur l'élément mobile en fonction de sa position angulaire a. Cette courbe correspond à la somme des courbes $C_1$ et $C_4$.

Pour réaliser cette simulation, l'ensemble comprenant les serges 13, 33 du dispositif 2 a été immobilisé et le moment nécessaire pour maintenir l'ensemble comprenant les moyeux 12, 32 en position a été mesuré pour une plage de positions angulaires a.

Dans le dispositif 2 selon le second mode de réalisation de l'invention représenté à la figure 9b, il n'existe pas de position d'équilibre d'armage à proprement parler. A l'état de repos du dispositif 2, l'unité 10 est armée de 13°, l'unité 30 est armée de 31 ° et la rotation de l'élément mobile comprenant les moyeux 12, 32 n'est possible que dans le sens horaire. Le dispositif 2 est en appui contre la butée 5 qui empêche la rotation de l'élément mobile dans le sens anti-horaire.

Comme cela est visible sur la figure 10, tant que la position $\alpha$ est telle que l'armage de chacune des deux unités reste dans la plage de valeur $[\theta_{min}, \theta_{max}]$ qui lui est associée, en l'espèce, tant que l'armage de chacune des deux unités reste dans la plage de valeurs [13°, 31°] qui lui est associée, les moments de rappel exercés par les deux unités 10, 30 sur l'élément mobile sont tous deux sensiblement constants et se compensent de sorte que le moment de rappel résultant sur l'élément mobile est sensiblement constant et abaissé par rapport au moment de rappel associé à l'unité 10 considérée seule. Cela correspond à une plage de positions angulaires $\alpha$ de l'élément mobile par rapport à l'élément fixe de 18°.

Le dispositif 2 selon le second mode de réalisation de l'invention présente l'avantage de guider en rotation sans frottement tout en pouvant ajuster la valeur du moment de rappel s'exerçant sur l'élément mobile. En effet, ce moment de rappel s'obtient en faisant la différence entre les moments de rappel exercés par chacune des unités 10, 30 du dispositif 2. Il est ainsi possible d'obtenir un guidage en rotation avec un moment de rappel très faible et avec une raideur importante en dehors du plan de pivotement tout en ayant des unités qui exercent chacune un moment de rappel pouvant être important.

La figure 12 illustre une bascule d'embrayage 7 de chronographe portant une roue d'embrayage 6 guidée en rotation par un dispositif 2 selon le second mode de réalisation de l'invention. Ce dispositif 2 est similaire à celui représenté à la figure 11 et diffère de ce dernier en ce que les lames élastiques d'une de ses unités, à savoir l'unité 30, sont moins épaisses que celles de l'autre unité 10. La bascule d'embrayage 7 représentée à la figure 12 est chassée sur l'axe du dispositif 2, entre les deux unités 10, 30 dont les serges 13, 33 sont respectivement chassées dans un pont (non représenté) et dans la platine 8 du mécanisme horloger.

Le dispositif selon l'invention permet un guidage précis, sans frottements, d'un composant mobile en rotation, ce guidage se faisant avec un moment de rappel sensiblement constant dont la valeur peut être ajustée typiquement à une valeur faible voire sensiblement nulle bien que ce dispositif comprenne des organes élastiques de raideur pouvant être importante.

Il apparaitra clairement à l'homme du métier que la présente invention n'est en aucun cas limitée aux modes de réalisation présentés dans les figures.

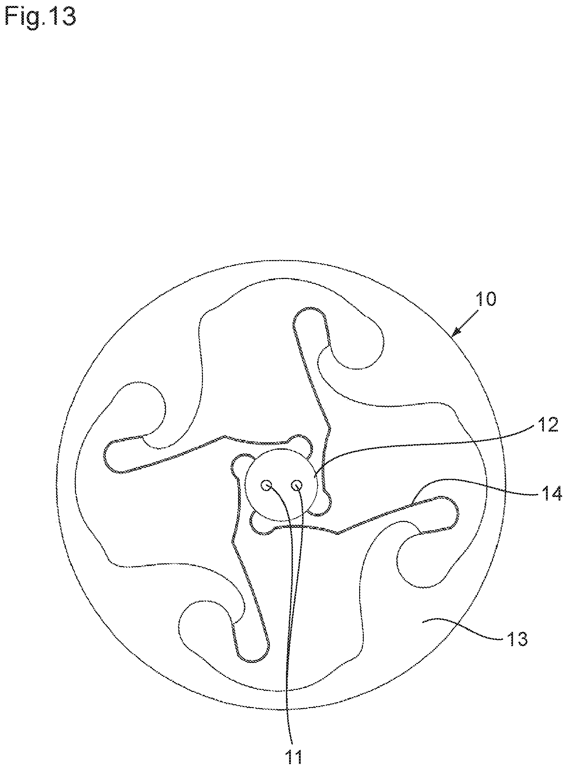

Il est par exemple très bien envisageable de réaliser un dispositif selon l'invention comprenant des unités avec des lames élastiques de formes différentes de celles représentées dans les figures et/ou dont le nombre de lames élastiques est différent de celui représenté dans les figures, elles peuvent notamment prendre une forme telle que représentée à la figure 13. La hauteur, la longueur, l'épaisseur et/ou le matériau des lames élastiques peuvent également être modifiés pour ajuster la valeur du moment de rappel élastique sensiblement constant.

## Revendications

1. Dispositif (1 ; 2) comprenant un élément fixe (13, 23, 33), un élément mobile (12, 22, 32) et des premier (14) et deuxième (24 ; 34) organes élastiques reliant l'élément fixe (13, 23, 33) et l'élément mobile (12, 22, 32) et étant agencés pour guider l'élément mobile (12, 22, 32) en rotation par rapport audit élément fixe (13, 23, 33), dispositif dans lequel chacun des premier (14) et deuxième (24 ; 34) organes élastiques est agencé pour exercer sur l'élément mobile (12, 22, 32) un moment de rappel élastique sensiblement constant sur une plage prédéterminée de positions angulaires de l'élément mobile (12, 22, 32) par rapport à l'élément fixe (13, 23, 33) d'au moins 10°, les moments de rappel élastique exercés par les premier (14) et deuxième (24 ; 34) organes élastiques se compensant au moins partiellement dans toute ladite plage prédéterminée.

2. Dispositif (1 ; 2) selon la revendication 1, **caractérisé en ce que** ladite plage prédéterminée de positions angulaires est d'au moins 15°, de préférence d'au moins 20°, de préférence d'au moins 25°.

3. Dispositif (1 ; 2) selon la revendication 1 ou 2, **caractérisé en ce qu'**il comprend une première unité monolithique (10) comprenant une première partie de l'élément fixe, ledit premier organe élastique (14) et une première partie de l'élément mobile, ledit premier organe élastique (14) reliant lesdites premières parties, et une deuxième unité monolithique (20 ; 30) comprenant une seconde partie de l'élément fixe, ledit second organe élastique (24 ; 34) et une seconde partie de l'élément mobile, ledit second organe élastique (24 ; 34) reliant lesdites secondes parties.

4. Dispositif (1 ; 2) selon la revendication 3, **caractérisé en ce que** les deux unités (10, 20, 30) sont monolithiques l'une avec l'autre.

5. Dispositif (1 ; 2) selon la revendication 3 ou 4, **caractérisé en ce que** les première et seconde parties de l'élément fixe comprennent chacune un moyeu (12, 22, 32) et **en ce que** les première et seconde parties de l'élément mobile comprennent chacune une serge (13, 23, 33) ; ou **en ce que** les première et seconde parties de l'élément fixe comprennent chacune une serge (13, 23, 33) et **en ce que** les première et seconde parties de l'élément mobile comprennent chacune un moyeu (12, 22, 32).

6. Dispositif (1 ; 2) selon la revendication 5, **caractérisé en ce que** les serges (13, 23, 33) sont en forme de cercle fermé ou d'un ou plusieurs arc(s) de cercle.

7. Dispositif (1 ; 2) selon l'une des revendications précédentes, **caractérisé en ce que** chacun desdits premier et second organes élastiques comprend plusieurs lames élastiques (14, 24, 34).

8. Dispositif (1 ; 2) selon la revendication 7 lorsque celle-ci dépend de l'une des revendications 3 à 6, **caractérisé en ce que** les dites lames élastiques (14, 24, 34) sont uniformément réparties autour du moyeu (12, 22, 32) de l'unité monolithique (10, 20, 30) à laquelle elles appartiennent.

9. Dispositif (1 ; 2) selon l'une des revendications 7 et 8, **caractérisé en ce que** chacune des lames élastiques (14, 24, 34) de chacune desdites unités (10, 20, 30) est de forme sinueuse.

10. Dispositif (1 ; 2) selon l'une des revendications 7 à 9, **caractérisé en ce que** la forme géométrique de chaque lame élastique (14, 24, 34) de chacune desdites unités (10, 20, 30) est une courbe de Bézier ou une succession de courbes de Bézier.

11. Dispositif (1 ; 2) selon l'une des revendications 5 2. et 6 ou selon l'une des revendications 7 à 10 lorsque ces dernières dépendent de l'une des revendications 3 à 6, **caractérisé en ce que** chacune des unités (10, 20, 30) possède un sens de rotation privilégié de sa serge (13, 23, 33) par rapport à son moyeu (12, 22, 32) et est apte à exercer un moment de rappel élastique sensiblement constant sur une plage de positions angulaires [$\theta_{min}$, $\theta_{max}$] de sa serge (13, 23, 33) par rapport à son moyeu (12, 22, 32), $\theta$ étant croissant dans le sens de rotation privilégié de l'unité (10, 20, 30) considérée, **en ce que** les sens de rotation privilégiés de chacune des unités (10, 20, 30) sont opposés et **en ce que**, à l'état de repos du dispositif (1 ; 2), chacune desdites unités (10, 20, 30) est armée d'un angle $\theta_{arm}$, cet angle $\theta_{arm}$ étant, pour chaque unité (10, 20, 30) compris entre $\theta_{min}$ et $\theta_{max}$ de ladite unité (10, 20, 30), $\theta_{min}$, $\theta_{arm}$ et/ou $\theta_{max}$ pouvant être identiques ou différents d'une unité à l'autre.

12. Dispositif (1 ; 2) selon la revendication 11, **caractérisé en ce que**, pour chacune desdites unités (10, 20, 30), $\theta_{arm}$ = $\theta_{min}$ + (($\theta_{max}$-$\theta_{min}$)/2).

13. Dispositif (1) selon l'une des revendications précédentes, **caractérisé en ce que** les moments de rappel élastique exercés par les premier (14) et deuxième (24) organes élastiques se compensent presque totalement dans toute ladite plage prédéterminée.

14. Dispositif (1) selon la revendication 13, **caractérisé en ce que** les premier (14) et deuxième (24) organes élastiques sont identiques.

15. Dispositif (1 ; 2) selon l'une des revendications précédentes, **caractérisé en ce qu'**il s'agit d'un dispositif horloger.

16. Procédé de réalisation d'un dispositif (1 ; 2) selon l'une des revendications 5 , 6 et 15 ou selon l'une des revendications 7 à 14 lorsque ces dernières dépendent de l'une des revendications 5 et 6, **caractérisé en ce qu'**il comprend les étapes successives suivantes :

    a. Réaliser un ensemble de deux unités monolithiques (10, 20, 30) dont

        (i) les moyeux (12, 22, 32) desdites deux unités (10, 20, 30) ou
        (ii) les serges (13, 23, 33) desdites deux unités (10, 20, 30) sont solidaires en rotation l'un(e) de l'autre;

    b. Armer chacune desdites deux unités (10, 20, 30)
    c. Rendre solidaire en rotation ceux des moyeux (12, 22, 32) ou des serges (13, 23, 33) qui ne le sont pas à l'issue de l'étape a.

17. Procédé de réalisation d'un dispositif selon la revendication 16, **caractérisé en ce que** l'étape (a)(i) est réalisée par introduction de goupilles (4) dans des trous (11, 21, 31) des moyeux (12, 22, 32) ou par fixation desdits moyeux (12, 22, 32) à un support et **en ce que** l'étape a(ii) est réalisée par insertion de goupilles (3) dans des ouvertures (15, 25) des serges (13, 23, 33) ou par fixation desdites serges (13, 23, 33) à un support.

18. Ensemble horloger comprenant un dispositif (1 ; 2) selon l'une des revendications 1 à 15 et un composant horloger solidaire en rotation de l'élément mobile.

19. Ensemble horloger selon la revendication 18, **caractérisé en ce que** le composant horloger est une ancre d'échappement, un levier ou une bascule, ledit levier ou bascule étant par exemple une bascule d'embrayage, un marteau, en particulier un marteau de chronographe, ou un bloqueur, en particulier un bloqueur de chronographe.

20. Pièce d'horlogerie, telle qu'une montre bracelet, comprenant un ensemble horloger selon l'une des revendications 18 ou 19.

**Patentansprüche**

1. Vorrichtung (1; 2), die ein festes Element (13, 23, 33), ein bewegliches Element (12, 22, 32) und ein erstes (14) und ein zweites (24; 34) elastisches Organ umfasst, die das feste Element (13, 23, 33) und das bewegliche Element (12, 22, 32) verbinden und gestaltet sind, um das bewegliche Element (12, 22, 32) drehbar in Bezug auf das feste Element (13, 23, 33) zu führen, wobei jedes von dem ersten (14) und dem zweiten (24; 34) elastischen Organ gestaltet ist, um auf das bewegliche Element (12, 22, 32) ein elastisches Rückstellmoment auszuüben, das über einen vorbestimmten Bereich von Winkelpositionen des beweglichen Elements (12, 22, 32) in Bezug auf das feste Element (13, 23, 33) von mindestens 10 ° im Wesentlichen konstant ist, wobei die elastischen Rückstellmomente, die von dem ersten (14) und dem zweiten (24; 34) elastischen Organ ausgeübt werden, sich in dem gesamten vorbestimmten Bereich zumindest teilweise ausgleichen.

2. Vorrichtung (1; 2) nach Anspruch 1, **dadurch gekennzeichnet, dass** der vorbestimmte Bereich von Winkelpositionen mindestens 15°, vorzugsweise mindestens 20°, vorzugsweise mindestens 25° beträgt.

3. Vorrichtung (1; 2) nach Anspruch 1 oder 2, **dadurch gekennzeichnet, dass** sie eine erste monolithische Einheit (10), die einen ersten Teil des festen Elements, das erste elastische Organ (14) und einen ersten Teil des beweglichen Elements umfasst, wobei das erste elastische Organ (14) die ersten Teile verbindet, und eine zweite monolithische Einheit (20; 30) umfasst, die einen zweiten Teil des festen Elements, das zweite elastische Organ (24; 34) und einen zweiten Teil des beweglichen Elements umfasst, wobei das zweite elastische Organ (24; 34) die zweiten Teile verbindet.

4. Vorrichtung (1; 2) nach Anspruch 3, **dadurch gekennzeichnet, dass** die zwei Einheiten (10, 20, 30) miteinander monolithisch sind.

5. Vorrichtung (1; 2) nach Anspruch 3 oder 4, **dadurch gekennzeichnet, dass** der erste und der zweite Teil des festen Elements jeweils eine Nabe (12, 22, 32) umfassen, und dadurch, dass der erste und der zweite Teil des beweglichen Elements jeweils einen Fußkreis (13, 23, 33) umfassen; oder dadurch, dass der erste und der zweite Teil des festen Elements jeweils einen Fußkreis (13, 23, 33) umfassen, und dadurch, dass der erste und der zweite Teil des beweglichen Elements jeweils eine Nabe (12, 22, 32) umfassen.

6. Vorrichtung (1; 2) nach Anspruch 5, **dadurch gekennzeichnet, dass** die Fußkreise (13, 23, 33) die Form eines geschlossenen Kreises oder eines oder mehrerer Kreisbögen aufweisen.

7. Vorrichtung (1; 2) nach einem der vorhergehenden Ansprüche, **dadurch gekennzeichnet, dass** jedes von dem ersten und dem zweiten elastischen Organ mehrere elastische Klingen (14, 24, 34) umfasst.

8. Vorrichtung (1; 2) nach Anspruch 7, wenn dieser von einem der Ansprüche 3 bis 6 abhängig ist, **dadurch gekennzeichnet, dass** die elastischen Klingen (14, 24, 34) gleichförmig um die Nabe (12, 22, 32) der monolithischen Einheit (10, 20, 30) zu der sie gehören, verteilt sind.

9. Vorrichtung (1; 2) nach einem der Ansprüche 7 und 8, **dadurch gekennzeichnet, dass** jede der elastischen Klingen (14, 24, 34) von jeder der Einheiten (10, 20, 30) eine gewundene Form aufweist.

10. Vorrichtung (1; 2) nach einem der Ansprüche 7 bis 9, **dadurch gekennzeichnet, dass** die geometrische Form von jeder elastischen Klinge (14, 24, 34) von jeder der Einheiten (10, 20, 30) eine Bezierkurve oder eine Folge von Bezierkurven ist.

11. Vorrichtung (1; 2) nach einem der Ansprüche 5 und 6 oder nach einem der Ansprüche 7 bis 10, wenn diese letzteren von einem der Ansprüche 3 bis 6 abhängig sind, **dadurch gekennzeichnet, dass** jede der Einheiten (10, 20, 30) einen bevorzugten Drehsinn ihres Fußkreises (13, 23, 33) in Bezug auf ihre Nabe (12, 22, 32) aufweist und geeignet ist, ein elastisches Rückstellmoment auszuüben, das über einen Bereich von Winkelpositionen [$\theta_{min}$, $\theta_{max}$] ihres Fußkreises (13, 23, 33) in Bezug auf ihre Nabe (12, 22, 32) im Wesentlichen konstant ist, wobei $\theta$ im bevorzugten Drehsinn der betrachteten Einheit (10, 20, 30) zunimmt, und dadurch, dass die bevorzugten Drehsinne von jeder der Einheiten (10, 20, 30) entgegengesetzt sind, und dadurch, dass im Ruhezustand der Vorrichtung (1; 2) jede der Einheiten (10, 20, 30) um einen Winkel $\theta_{arm}$ gespannt ist, wobei dieser Winkel $\theta_{arm}$ für jede Einheit (10, 20, 30) zwischen dem $\theta_{min}$ und dem $\theta_{max}$ der Einheit (10, 20, 30) enthalten ist, wobei $\theta_{min}$, $\theta_{arm}$ und/oder $\theta_{max}$ identisch oder von einer Einheit zur anderen unterschiedlich sein können.

**12.** Vorrichtung (1; 2) nach Anspruch 11, **dadurch gekennzeichnet, dass** für jede der Einheiten (10, 20, 30) $\theta_{arm}$ = $\theta_{min}$ + (($\theta_{max}$ - $\theta_{min}$)/2).

**13.** Vorrichtung (1) nach einem der vorhergehenden Ansprüche, **dadurch gekennzeichnet, dass** die elastischen Rückstellmomente, die von dem ersten (14) und dem zweiten (24) elastischen Organ ausgeübt werden, sich in dem gesamten vorbestimmten Bereich fast vollständig ausgleichen.

**14.** Vorrichtung (1) nach Anspruch 13, **dadurch gekennzeichnet, dass** das erste (14) und das zweite (24) elastische Organ identisch sind.

**15.** Vorrichtung (1; 2) nach einem der vorhergehenden Ansprüche, **dadurch gekennzeichnet, dass** es sich um eine Uhrenvorrichtung handelt.

**16.** Verfahren zur Herstellung einer Vorrichtung (1; 2) nach einem der Ansprüche 5, 6 und 15 oder nach einem der Ansprüche 7 bis 14, wenn diese letzteren von einem der Ansprüche 5 und 6 abhängig sind, **dadurch gekennzeichnet, dass** es die folgenden aufeinanderfolgenden Schritte umfasst:

a. Herstellen eines Zusammenbaus zweier monolithischer Einheiten (10, 20, 30), von denen

(i) die Naben (12, 22, 32) der zwei Einheiten (10, 20, 30) oder
(ii) die Fußkreise (13, 23, 33) der zwei Einheiten (10, 20, 30) miteinander drehfest sind;

b. Spannen jeder der zwei Einheiten (10, 20, 30)
c. Drehfestmachen derjenigen der Naben (12, 22, 32) oder der Fußkreise (13, 23, 33), die dies am Ende des Schrittes a nicht sind.

**17.** Verfahren zur Herstellung einer Vorrichtung nach Anspruch 16, **dadurch gekennzeichnet, dass** der Schritt (a) (i) durch Einführung von Sperrstiften (4) in Löcher (11, 21, 31) der Naben (12, 22, 32) oder durch Fixierung der Naben (12, 22, 32) an einer Stütze ausgeführt wird, und dadurch, dass der Schritt a(ii) durch Einführung von Sperrstiften (3) in Öffnungen (15, 25) der Fußkreise (13, 23, 33) oder durch Fixierung der Fußkreise (13, 23, 33) an einer Stütze ausgeführt wird.

**18.** Uhrenbaugruppe, die eine Vorrichtung (1; 2) nach einem der Ansprüche 1 bis 15 und eine mit dem beweglichen Element drehfeste Uhrenkomponente umfasst.

**19.** Uhrenbaugruppe nach Anspruch 18, **dadurch gekennzeichnet, dass** die Uhrenkomponente ein Hemmungsanker, ein Hebel oder eine Wippe ist, wobei der Hebel oder die Wippe zum Beispiel eine Kupplungswippe, ein Hammer, insbesondere ein Chronographenhammer, oder ein Blockierhebel, insbesondere ein Chronographenblockierhebel, ist.

**20.** Uhr, wie beispielsweise einer Armbanduhr, die eine Uhrenbaugruppe nach einem der Ansprüche 18 oder 19 umfasst.

**Claims**

**1.** Device (1; 2) comprising a fixed element (13, 23, 33), a movable element (12, 22, 32) and first (14) and second (24; 34) elastic members connecting the fixed element (13, 23, 33) and the movable element (12, 22, 32) and being arranged to guide the movable element (12, 22, 32) in rotation with respect to said fixed element (13, 23, 33), a device in which each of the first (14) and second (24; 34) elastic members is arranged to exert on the movable element (12, 22, 32) an elastic return moment which is substantially constant over a predetermined range of angular positions of the movable element (12, 22, 32) with respect to the fixed element (13, 23, 33) of at least 10°, the elastic return moments exerted by the first (14) and second (24; 34) elastic members at least partially compensating for each other over the whole of said predetermined range.

**2.** Device (1; 2) as claimed in claim 1, **characterised in that** said predetermined range of angular positions is at least 15°, preferably at least 20°, preferably at least 25°.

**3.** Device (1; 2) as claimed in claim 1 or 2, **characterised in that** it comprises a first single-piece unit (10) comprising a first part of the fixed element, said first elastic member (14) and a first part of the movable element, said first elastic member (14) connecting said first parts, and a second single-piece unit (20; 30) comprising a second part of the fixed element, said second elastic member (24; 34) and a second part of the movable element, said second elastic member (24; 34) connecting said second parts.

4.  Device (1; 2) as claimed in claim 3, **characterised in that** the two units (10, 20, 30) form a single piece with each other.

5.  Device (1; 2) as claimed in claim 3 or 4, **characterised in that** the first and second parts of the fixed element each comprise a hub (12, 22, 32) and **in that** the first and second parts of the movable element each comprise a felloe (13, 23, 33); or **in that** the first and second parts of the fixed element each comprise a felloe (13, 23, 33) and **in that** the first and second parts of the movable element each comprise a hub (12, 22, 32).

6.  Device (1; 2) as claimed in claim 5, **characterised in that** the felloes (13, 23, 33) are in the form of a closed circle or one or more arcs of a circle.

7.  Device (1; 2) as claimed in any one of the preceding claims, **characterised in that** each of said first and second elastic members comprises a plurality of elastic strips (14, 24, 34).

8.  Device (1; 2) as claimed in claim 7, when this is dependent on one of claims 3 to 6, **characterised in that** said elastic strips (14, 24, 34) are uniformly distributed about the hub (12, 22, 32) of the single-piece unit (10, 20, 30) to which they belong.

9.  Device (1; 2) as claimed in any one of claims 7 and 8, **characterised in that** each of the elastic strips (14, 24, 34) of each of said units (10, 20, 30) is of a sinuous shape.

10. Device (1; 2) as claimed in any one of claims 7 to 9, **characterised in that** the geometric shape of each elastic strip (14, 24, 34) of each of said units (10, 20, 30) is a Bezier curve or a succession of Bezier curves.

11. Device (1; 2) as claimed in any one of claims 5 and 6 or as claimed in any one of claims 7 to 10 when the latter are dependent on any one of claims 3 to 6, **characterised in that** each of the units (10, 20, 30) has a favoured direction of rotation of its felloe (13, 23, 33) with respect to its hub (12, 22, 32) and is able to exert an elastic return moment which is substantially constant over a range of angular positions $[\theta_{min}, \theta_{max}]$ of its felloe (13, 23, 33) with respect to its hub (12, 22, 32), $\theta$ increasing in the favoured direction of rotation of the unit (10, 20, 30) in question, **in that** the favoured directions of rotation of each of the units (10, 20, 30) are opposing, and **in that**, when the device (1; 2) is in the inoperative state, each of said units (10, 20, 30) is wound by an angle $\theta_{arm}$, this angle $\theta_{arm}$ being, for each unit (10, 20, 30), between $\theta_{min}$ and $\theta_{max}$ of said unit (10, 20, 30), $\theta_{min}$, $\theta_{arm}$ and/or $\theta_{max}$ being able to be identical or different from one unit to the other.

12. Device (1; 2) as claimed in claim 11, **characterised in that**, for each of said units (10, 20, 30), $\theta_{arm} = \theta_{min} + ((\theta_{max} - \theta_{min})/2)$.

13. Device (1) as claimed in any one of the preceding claims, **characterised in that** the elastic return moments exerted by the first (14) and second (24) elastic members compensate for each other almost entirely over the whole of said predetermined range.

14. Device (1) as claimed in claim 13, **characterised in that** the first (14) and second (24) elastic members are identical.

15. Device (1; 2) as claimed in any one of the preceding claims, **characterised in that** it is a timepiece device.

16. Method of producing a device (1; 2) as claimed in any one of claims 5, 6 and 15, or as claimed in any one of claims 7 to 14 when the latter are dependent on any one of claims 5 and 6, **characterised in that** it comprises the following successive steps:

    a. producing an assembly of two single-piece units (10, 20, 30) of which

        (i) the hubs (12, 22, 32) of said two units (10, 20, 30) or
        (ii) the felloes (13, 23, 33) of said two units (10, 20, 30) are arranged for conjoint rotation with each other;

b. winding each of said two units (10, 20, 30)

c. causing those of the hubs (12, 22, 32) or of the felloes (13, 23, 33) which are not arranged for conjoint rotation at the end of step a. to be arranged for conjoint rotation.

17. Method for producing a device as claimed in claim 16, **characterised in that** step a.(i) is carried out by the introduction of pins (4) into holes (11, 21, 31) in the hubs (12, 22, 32) or by fixing said hubs (12, 22, 32) to a support and **in that** step a.(ii) is carried out by insertion of pins (3) into openings (15, 25) in the felloes (13, 23, 33) or by fixing said felloes (13, 23, 33) to a support.

18. Timepiece assembly comprising a device (1; 2) as claimed in any one of claims 1 to 15 and a timepiece component arranged for conjoint rotation with the movable element.

19. Timepiece assembly as claimed in claim 18, **characterised in that** the timepiece component is an escapement pallet, a lever or a lever arm, said lever or lever arm being e.g. a coupling lever arm, a hammer, in particular a chronograph hammer, or a blocking lever, in particular a chronograph blocking lever.

20. Timepiece, such as a wristwatch, comprising a timepiece assembly as claimed in one of claims 18 or 19.

Fig.1

Fig.2

Fig.3

Fig.4

## Fig.5

Moment de rappel élastique $M_{10}$ (N.mm)

## Fig.6

## Fig.7a

## Fig.7b

Fig.8

Moment de rappel élastique M (N.mm)

Fig.10

Moment de rappel élastique M (N.mm)

Fig.9a

Fig.9b

Fig.11

Fig.12

Fig.13

**EP 3 707 565 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **LEVI CLIFFORD LEISHMAN.** *Toward the Design of a Statically Balanced Fully Compliant Joint for use in Haptic Interfaces, http://hdl.lib.byu.edu/1877/ etd4781*

- **CHAO-CHIEH LAN et al.** Design of adjustable constant-force forceps for robot-assisted surgical manipulation. *IEEE International Conference on robotics and automation Shanghai International Conference Center,* 09 Mai 2011